# EUROPEAN PATENT APPLICATION

(11) **EP 1 978 072 A1**
(43) Date of publication of application: **08.10.2008**
(21) Application number: 07706743.7
(22) Date of filing: 15.01.2007
(51) Int. Cl.: C09K 11/08, B82B 1/00, B82B 3/00, C09K 11/56, C09K 11/59, C09K 11/88

(54) **SEMICONDUCTOR NANOPARTICLE HAVING CORE/SHELL STRUCTURE AND PROCESS FOR PRODUCING THE SAME**

(30) Priority: 27.01.2006 JP 2006019242
(71) Applicant: Konica Minolta Medical & Graphic, Inc., Hino-shi, Tokyo 191-8511 (JP)
(72) Inventor: GOAN, Kazuyoshi, Tokyo 1630512 (JP); OKADA, Hisatake, Tokyo 1630512 (JP); TSUKADA, Kazuya, Tokyo 1630512 (JP)
(74) Representative: Gille Hrabal Struck Neidlein Prop Roos
(86) International application number: PCT/JP2007/050409
(87) International publication number: WO 2007/086267

(57) **Abstract**

Semiconductor nanoparticles having a core/shell structure in which the ratio of the shell thickness to the particle diameter of the core part is a value optimal for an optical property required of an optical element. The semiconductor nanoparticles have a core/shell structure in which the thickness of the shell part is not larger than one-half the particle diameter of the core part. The particle diameter of the core part is less than 20 nm and the thickness of the shell part is 0.2 nm or larger. Alternatively, the particle diameter of the core part is 20-100 nm and the thickness of the shell part is at last 1/100 the particle diameter of the core part. The core part contains at least one element selected from the group consisting of B, C, N, Al, Si, P, S, Zn, Ga, Ge, As, Se, Cd, In, Sb, and Te. The semiconductor nanoparticles are **characterized in that** the shell part comprises a composition having a larger band gap than the core part.

## Description

### TECHNICAL FIELD

The present invention relates to a nanosized semiconductor particle having a core/shell structure and specifically to the nanosized semiconductor particle having a core/shell structure in which a shell portion has a thickness of not more than 1/2 of a particle diameter of a core portion, and a manufacturing method thereof.

### BACKGROUND

It is known that among ultrafine particles of semiconductors or metals, nanosized particles having a particle diameter smaller than the wavelength of an electron (approximately 10 nm), on which the influence of size finiteness on the movement of electrons increases as a quantum size effect, exhibit a specific physical property different from that of the bulk body (Non-Patent Document 1). Nanosized semiconductor particles having a core/shell structure which are covered with a material different from the core portion of the nanoparticles can be functionalized without varying the size or the shape of core particles or are expected to display a characteristic different from that of the bulk material of the core or the shell, therefore, they are noted as a novel and highly active catalyst, as a photofunctional material or as a material for optical elements. When the surface of light-emitting nanoparticles is exposed, a number of defects existing on the nanoparticles surface become an emission killer, whereby emission efficiency is lowered. To overcome this, known is a method in which the emission intensity can be enhanced by covering the nanoparticles with a shelling material exhibiting a band gap greater than the band gap corresponding to the emission wavelength of the nanoparticles, and thereby form a core/shell structure.

As to a luminescent nanosized particle having a core/shell structure, an ultra-fine particle having an insulating layer on the silicon nucleus surface has been disclosed in the past as a nonlinear optical material. This is to be useful as a high luminance light emitting material capable of producing high quantum efficiency (refer to Patent Document 1).

Further, a phosphor particle composed of a nanosized structure crystal whose surrounding is coated with a glass component is capable of producing stimulating light emission even at low voltage, and exhibits high light emission efficiency (refer to Patent Document 2).

Not more than 10 nm is a particle diameter of a phosphor core containing the first addition element to form an acceptor level and the second addition component to form a donor level in a semiconductor containing ZnS as the first main component and a II - VI group compound semiconductor as the second component which may be partially contained, a core/shell structure dispersed in a shell material having a larger band gap than a band gap corresponding to emission wave length of the phosphor is contained, and phosphor exhibiting high light emission efficiency is disclosed (refer to Patent Document 1).

Increasing of band gap energy in this case is accomplished by generating a quantum size effect via minimization of size of the core particle down to nanosized particle, and further producing a core/shell structure as described above, but how optical properties of the nanosized semiconductor particle is influenced by a ratio of the core portion to a shell layer in size has not yet been studies so far.
Patent Document 1: Japanese Patent O.P.I. Publication No. 5-224261
Patent Document 2: Japanese Patent O.P.I. Publication No. 2000-265166
Patent Document 3: Japanese Patent O.P.I. Publication No. 2005-120117
Non-Patent Document 1: Nikkei Sentan Gijutsu (Nikkei Advanced Technology), Jan. 27, 2003, pages 1-4.

### DISCLOSURE OF THE INVENTION

### PROBLEMS TO BE SOLVED BY THE INVENTION

With respect to optical properties of the nanosized semiconductor particle having a core/shell structure as described above, influence of the shell layer thickness has not been known. After considerable effort during intensive studies, the inventors have found out that in the case of the ratio of shell thickness / core portion particle diameter falling within a given range, improved light emission efficiency together with emission stability can be obtained, resulting in the present invention on the basis of this knowledge. It is an object of the present invention to provide a nanosized semiconductor particle having a core/shell structure possessing a optimal ratio of shell thickness / core portion particle diameter as to optical properties of an optical element, and to provide a manufacturing method thereof.

### MEANS TO SOLVE THE PROBLEMS

A nanosized semiconductor particle of the present invention possesses a core/shell structure in which a shell portion has a thickness of not more than 1/2 of a particle diameter of a core portion.

It is a feature that the core portion has a particle diameter of less than 20 nm, and the shell portion has a thickness of at least 0.2 nm.

Or, it is a feature that the core portion has a particle diameter of 20 - 100 nm, and the shell portion has a thickness of at least 1/100 of a particle diameter of the core portion.

Further, it is a feature that the core portion possesses at least one element selected from the group consisting of B, C, N, Al, Si, P, S, Zn, Ga, Ge, As, Se, Cd, In, Sb and Te.

It is also a feature that the shell portion has a composition exhibiting a larger band gap than that of the core portion.

It is preferable that the core portion is composed of a silicon nucleus, and the shell portion is composed of a layer made of silicon oxide as a main component.

It is further preferable that the core portion is composed of a single crystal.

In the present invention, included is a method of manufacturing the nanosized semiconductor particle, comprising the step of adjusting a reaction condition during formation of the shell portion, wherein the shell portion has a minimal thickness of 0.2 nm, and has a thickness of 1/100 and 1/2 of a particle diameter of the core portion.

Included is a method of manufacturing a nanosized semiconductor particle in which a core portion is composed of a silicon nucleus, and a shell portion is composed of a layer made of silicon oxide as a main component, comprising the steps of (i) conducting a reaction by adding a reducing agent into a solution obtained via mixing of a silicon tetrachloride solution and an organic solvent containing a surfactant; (ii) subsequently forming liquid droplets for nanosized silicon particles prepared in a micelle of the surfactant via a spraying treatment in oxidant atmosphere to be dispersed; and (iii) further conducting a calcination treatment while maintaining a dispersion state in a vapor phase, wherein the shell portion has a minimal thickness of 0.2 nm, and has a thickness of 1/100 - 1/2 of a particle diameter of the core portion via adjustment of a duration of the spraying treatment in step (ii).

### EFFECT OF THE INVENTION

A nanosized semiconductor particle of the present invention having a core/shell structure generates a quantum size effect, a quantum confinement effect and so forth effectively and improves quantum efficiency, and light emission is stabilized since a ratio of shell thickness to a core portion particle diameter falls within a given optimal range. Accordingly, the nanosized semiconductor particle of the present invention is a practically preferable particle, and is useful as a high luminance light emitting member or a light emitting element.

### BRIEF DESCRIPTION OF THE DRAWINGS

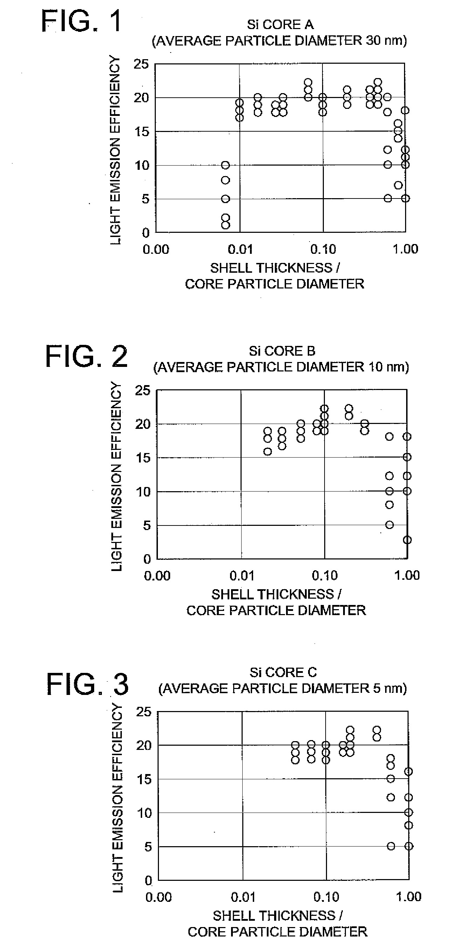

[Fig, 1] Fig. 1 is a graphic chart showing the relationship between light emission efficiency and shell thickness / core particle diameter (core/shell ratio) in the case of Si core A.
[Fig. 2] Fig. 2 is a graphic chart showing the relationship between light emission efficiency and shell thickness / core particle diameter (core/shell ratio) in the case of Si core B.
[Fig. 3] Fig. 3 is a graphic chart showing the relationship between light emission efficiency and shell thickness / core particle diameter (core/shell ratio) in the case of Si core C.
[Fig. 4] Fig. 4 is a graphic chart showing the relationship between light emission efficiency and shell thickness / core particle diameter (core/shell ratio) in the case of Si core D.
[Fig. 5] Fig. 5 shows a mixing apparatus and a spray baking apparatus which are employed for covering a CdSe core with a shell portion ZnS layer.
[Fig. 6] Fig. 6 is a graphic chart showing the relationship between light emission efficiency and shell thickness / core particle diameter (core/shell ratio) in the case of CdSe core A.
[Fig. 7] Fig. 7 is a graphic chart showing the relationship between light emission efficiency and shell thickness / core particle diameter (core/shell ratio) in the case of CdSe core B.
[Fig. 8] Fig. 8 is a graphic chart showing the relationship between light emission efficiency and shell thickness / core particle diameter (core/shell ratio) in the case of CdSe core C.
[Fig. 9] Fig. 9 is a graphic chart showing the relationship between light emission efficiency and shell thickness / core particle diameter (core/shell ratio) in the case of CdSe core D.

### DESCRIPTION OF THE PREFERRED EMBODIMENTS

### Nanosized semiconductor particle

"Nanosized semiconductor particles" of the present invention refer to ultrafine semiconductor particles exhibiting a particle diameter in the order of nanometers. The nanosized semiconductor particles may be in a spherical form, a rod form, a planar form or a tube form, but the nanosized semiconductor particles obtained by a manufacturing method of the present invention are assumed to be spherical or approximately spherical, and the particle size thereof represents a particle diameter. The nanosized semiconductor particles of the present invention usually exhibit 1000 nm or less of an overall particle diameter (which is the diameter of the combined portion having a core and a shell, but also includes the chain in cases where a polymer chain thereof is attached onto the shell surface).

### • Core/shell structure

It is a feature that the nanosized semiconductor particles of the present invention are those having a core/shell structure, and as a ratio of shell portion size to core portion size, a shell portion has a thickness of not more than 1/2 of a particle diameter of a core portion. Herein, "core/shell structure" means a double structure comprised of a nanoparticle at a central portion as a core portion and a layer covering the core particle surface as a shell portion.

When the nanosized semiconductor particle surface is exposed, a number of defects on the nanosized semiconductor particle surface have functioned as an emission killer, resulting in reduced light emission intensity, which is prevented by forming a core/shell structure in the nanosized semiconductor particle. Preferable is a structure in which a shell portion having a composition exhibiting a larger band gap than that of the core portion results in enhanced light emission intensity, leading to longer life of light emission and enhanced luminance. The nanosized semiconductor particle structure will be further described in detail.

The material at the core portion of the nanosized semiconductor particle of the present invention preferably contains at least one element selected from the group consisting of B, C, N, Al, Si, P, S, Zn, Ga, Ge, As, Se, Cd, In, Sb and Te. At least one element of Si and Ge is more preferable, and one of Si and its compound, or one of Ge and its compound is still more preferable. In the case of the nanosized semiconductor particle in which the core portion is made of Si or Ge, when the particle size is reduced down to a region producing a quantum confinement effect, the band gap energy expands up to the visible region, whereby a light-emitting phenomenon is observed.

In the preferable embodiment of nanosized semiconductor particles each having a core/shell structure, the core portion has a particle diameter of 1 - 100 nm, the shell portion has a thickness of at least about 0.2 - 0.3 nm, and the nanosized semiconductor particle has a shell portion having a thickness of 1/100 - 1/2 of a particle diameter of a core portion, as a ratio of the shell thickness to the particle diameter of the core portion.

The core portion is preferably composed of a single crystal. The reason of this is that in the case of optical elements, for example, phosphor particles, high light emission efficiency can be obtained (refer to Patent Document 2).

The shell portion is composed of a layer covering the core portion. The material constituting the shell portion is preferably composed of a compound of II - VI group. In this case, in view of a core/shell structure, the shell portion is desired to have a composition exhibiting a larger band gap than that of the core portion.

Such the nanosized semiconductor particles are not specifically limited, and examples thereof include semiconductor crystals, for example, a II-VI group compound such as CdS or CdSe; a I-VII group compound such as CuCl; a III-V group compound such as InAs; and a IV group semiconductor. Specific examples of the core/shell structure include a core/shell structure composed of Si as a core and SiO₂ as a shell; a core/shell structure composed of CdS as a core and SiO₂ as a shell; a core/shell structure composed of CdS a core and CdSe as a shell; a core/shell structure composed of CdSe as a core and CdS as a shell; a core/shell structure composed of CdS as a core and ZnS as a shell; and a core/shell structure composed of CdSe as a core and ZnSe as a shell.

It is preferable that the core portion is a silicon nucleus, and the shell portion is composed of a layer made of silicon oxide as a main component. The layer mainly composed of silicon oxide means a shell layer containing silicon dioxide (SiO₂) as a main component. The silicon nucleus of the core portion is preferably composed of a single crystal. In the case of nanosized semiconductor particles each having a core/shell structure, the excitation energy for Si in the core portion is 1.1 eV and that for SiO₂ in the shell portion is 8 eV, whereby the band gap energy is larger than that of CdSe/ZnS nanoparticles {core portion (ZnS)}; 3.6 eV and shell portion (CdSe); 1.7 eV}. In addition, silicon-silica type nanosized semiconductor particles reduce environmental load, and exhibit superior biostability.

### • Quantum size effect

A particle diameter of the core portion is 1 - 100 nm, preferably 1 - 50 nm, and more preferably 2 - 20 nm. In the case of a core portion particle diameter of less than 1 nm, it is not easy to adjust the particle diameter, and it is difficult to obtain uniform core particles. Further, in the case of the core portion particle diameter exceeding 100 nm, the property ends up with bulk properties. To allow nanosized particles to effectively exhibit a quantum effect, the core portion particle diameter should usually be at least 100 nm.

As described above, the inventors have found out that a ratio of the shell thickness to a particle diameter of the core portion is closely related with light emission of luminescent nanosized particle, and have conceived that light emission characteristics can be improved by appropriately adjusting the two. In the case of nanosized semiconductor particles of the present invention, in cases where the shell thickness is much thinner than the core particle diameter, light emission efficiency is low, and light emission is not stable. On the other hand, in cases where the shell thickness is much thicker than the core particle diameter, light stability is deteriorated. Therefore, the relationship between the core portion size and the shell portion size so as to obtain high light emission efficiency is specified as described below.

In the case of a core portion particle diameter of less than 20 nm, the shell portion has a thickness of at least 0.2 nm, and has a thickness of not more than 1/2 of a particle diameter of the core portion. In the case of the shell portion having a thickness of less than 0.2 nm, this is because the above-described results in an atom or a molecule. Further, in order to separate particle cores to each other, and avoid coagulation of core-to-core, the shell portion needs to have a thickness of at least 0.2 nm.

Such the particle diameter, as compared to a bulky structure, results in an excellent light absorption property and a light emission property via exciton confinement as a quantum effect and an electrostatic effect. Thus, the absorption spectrum and fluorescence spectrum are possible to be controlled by the particle diameter. Specifically, nanosized semiconductor particles exposed to stimulating light such as ultraviolet rays result in fluorescence at a specific wavelength depending on the particle diameter. Accordingly, nanosized semiconductor particle reagents differing in particle diameter enable multicolor emission from a single light source. Further, the reason why the shell portion has a thickness of not more than 1/2 of a particle diameter of the core portion is that the volume content of the core portion in nanosized particles is designed to be not too small, or in other words, a high occupied ratio of the light emission layer is designed to be made. According to this, high light emission efficiency is maintained, and the effect of obtaining stable light emission is produced. Accordingly, the appropriate adjustment of the ratio of shell thickness / core portion particle diameter so as to produce desired intensity of light emission has the advantage that stable light emission is possible to be obtained.

Nanosized semiconductor particles having a core portion particle diameter and a shell thickness falling within the foregoing range, which maximally enhance light emission efficiency and can optimally control or freely design emission spectrum, while maintaining light emission stability, are of great promise as luminous microparticles, for example, nanosized multi-color luminescence phosphor particles. These are applicable to fluorescent reagents or labeled substances, preferably in the state of a stably dispersed suspension or being fixed onto a substrate.

On the other hand, in the case of the core portion having a particle diameter of 20 - 100 nm, it is desired in view of light emission intensity and a particle diameter distribution that the shell portion has a thickness of at least 1/100 of a particle diameter of the core portion, and has a thickness of not more than 1/2 of a particle diameter of the core portion. In the case of the ratio of shell thickness / core particle diameter of less than 1/100, light emission intensity of nanosized semiconductor particles is lowered, resulting in a non-narrow particle diameter distribution. Further, in the case of the ratio exceeding 1/2, variation in size among nanosized particles is large though light emission intensity is slightly increased.

Japanese Patent O.P.I. Publication No. 2004-296781 discloses that nanosized silicon, which can directly contribute to emission color as a light-emitting device, can be controlled by conducting a hydrofluoric acid treatment or an oxidation treatment, whereby visible emission of red, green or blue is possible to be varied. Further, the shell portion thickness is set to at least 1/100 and not more than 1/2 of a particle diameter of the core portion to produce the effect of obtaining a stable light emission efficiency. Accordingly, a high luminance optical material, for example, a phosphor exhibiting a high quantum yield can be obtained by depositing nanosized semiconductor particles of the foregoing size on an appropriate substrate. Such the light-emitting material, which can be excited at a relatively low voltage and results in high-intensity emission, is practically preferred as a high luminance light emission member. Long-life of emission and stable emission lead easily to enhanced visibility via the emission, and the foregoing light-emitting material is specifically suitable for a phosphor used in flat panel displays and a solid state component for displays or illumination.

### Manufacturing method

As to nanosized semiconductor particles of the present invention, in the case of a core portion particle diameter of less than 20 nm, the shell portion has a thickness of at least 0.2 nm and has a thickness of not more than 1/2 of a particle diameter of the core portion. Further, in the case of a core portion particle diameter of 20 - 100 nm, the shell portion has a thickness of at least 1/100 and not more than 1/2 of a particle diameter of the core portion. Methods of preparing nanosized semiconductor particles each having a core/shell structure are not specifically limited, and there are known, for example, a vapor phase process and a liquid phase process (e.g., a reversed micelle method, a hot soap method, and a method employing coprecipitation).

Even though any of the methods is employed, nanosized semiconductor particles, in which the shell portion has a minimal thickness of 0.2 nm, and has a thickness of 1/100 and 1/2 of a particle diameter of the core portion, can be manufactured by appropriately adjusting the reaction condition during formation of the shell portion. That is, adjustment of a ratio of the core portion particle diameter / shell thickness depends on appropriately adjusting the formation condition during formation of the shell portion. Accordingly, when core particles having a predetermined average particle diameter are obtained, the shell portion thickness corresponding to the size depends on a method of coating core particles, but, for example, a concentration of a compound constituting the shell portion, contact time or contact method of the compound, reaction time, temperature, pressure, nozzle diameter and other treatment conditions may be adjusted so as to give a desired shell thickness. Selection and setting of the specific condition with respect to individual nanosized particles are possible to be arranged by those skilled in the art.

In the case of the vapor phase process, it is possible to control a core/shell structure precisely, it is preferable that a novel nanosized composite material exhibiting excellent optical properties can be obtained. Next, a method of manufacturing nanosized silicon particles will be described as an example.

Produced can be a nanosized semiconductor particle via a method of manufacturing the nanosized semiconductor particle in which a core portion is composed of a silicon nucleus, and a shell portion is composed of a layer made of silicon oxide as a main component, comprising the steps of (i) conducting a reaction by adding a reducing agent into a solution obtained via mixing of a silicon tetrachloride solution and an organic solvent containing a surfactant; (ii) subsequently forming liquid droplets for nanosized silicon particles prepared in reversed micelle of the surfactant via a spraying treatment in oxidant atmosphere to be dispersed; and (iii) further conducting a calcination treatment while maintaining a dispersion state in a vapor phase, wherein the shell portion has a minimal thickness of 0.2 nm, and has a thickness of 1/100 - 1/2 of a particle diameter of the core portion via adjustment of a duration of the spraying treatment in step (ii).

Since size of the core particle is specified by largeness of reversed micelle formed with a surfactant, it may be adjusted by the concentration ratio of the surfactant / silicon tetrachloride. In steps (ii) and (iii), since the core portion is made of oxidizable silicon, a layer made of silicon oxide (SiO₂) as a main component can be easily formed by conducting a oxidizing treatment around the core portion, and thickness of the layer can also be adjusted easily.

Examples of the surfactant include tetraoctylammonium bromide (TOAB), sodium bis [2-ethylhexyl] sulfosuccinate (AOT), trioctylphosphine oxide (TOPO), cetyltrimethylammonium bromide (CTAB), lauryldimethyl aminoacetic acid (LDA) and so forth.

Organic solvents are not specifically limited, but examples thereof include toluene, xylene, hexane, heptane, benzene, acetone, THF, MEK, dimethy formanido, dimethyl acetoamido, dimethyl sulfoxide, cyclohexane, dimethy ether, ethyl acetate and so forth.

Examples of the reducing agent include lithium aluminum hydride, sodium boron hydride, lithium aluminum hydride, dimethyl amineborane and so forth. Exemplified examples of the oxidative atmosphere also include oxygen gas, atmosphere for steam oxidation, and so forth.

In order to obtain roughly uniform nanosized particles each having a structure of Si core / SiO₂ shell exhibiting less variation in particle diameter distribution, the following method is preferred.
(i) An aqueous SiCl₄ solution and an organic solvent containing a surfactant, for example, a toluene solution of TOAB (tetraoctylammonium bromide) are mixed while stirring to obtain a raw material solution. A lithium aluminum hydride THF solution is added into the resulting, and the system is left standing for a given time. After deactivating an excessive reducing agent via addition of methanol,
(ii) liquid droplets for nanosized silicon particles prepared in reversed micelle of the surfactant are subsequently formed via a spraying treatment in oxidant atmosphere to be dispersed, and
(iii) a calcination treatment is further conducted while maintaining a dispersion state in a vapor phase to obtain nanosized semiconductor particles each in which the core portion is made of silicon, and the shell portion is made of silicon oxide (SiO₂).

Silicon can also be crystallized as a particle having a fine particle diameter by such the vapor phase method.

The shell thickness can be arranged to be made as desired size by adjusting a duration of the spraying treatment in the above-described step (ii). That is, in order to have a core/shell structure in which the shell portion has a thickness of not more than 1/2 of a particle diameter of the core portion, a calcination time may be adjusted in spraying treatment time and oxidant atmosphere, in such a way that the size distribution of the resulting nanosized silicon particles falls within the narrow range, and not more than 1/2 of the average particle diameter is achieved.

Specifically, in order to have an average particle diameter of the core portion to be less than 20 nm, size of reverse micelle may be adjusted by a concentration ratio of surfactant / silicon tetrachloride, for example, since size of the resulting nanosized silicon particle is specified by size of reversed micelle formed by the surfactant. Further, adjustment of the shell thickness depends on adjusting the spraying treatment time in oxidant atmosphere. That is, thickness of the shell portion becomes thinner by shortening the spraying treatment time in oxidant atmosphere.

The range or distribution of such the particle size can be observed employing a high resolution TEM (transmission electron microscope). According to the manufacturing method described above, nanosized semiconductor particles exhibiting a narrow particle diameter distribution can be efficiently manufactured.

In the case of nanosized semiconductor particles fixed on the substrate, a high frequency sputtering method is suitably applicable, as described in Japanese Patent O.P.I. Publication No. 2004-296781.

These materials used as described before are only examples of the preferred embodiment of the present invention. The present invention will be further described with reference to examples, but is not to be construed as being limited thereto. Numerical conditions such as a concentration or an amount of material used in examples, a treatment time or treatment temperature and treatment methods are only preferred examples of the present invention.

### EXAMPLE

### [Example 1]

### Preparation of Si/SiO₂

### (Preparation of core portion composed of Si particle)

After adding tetraoctylammonium bromide (TOAB) into 100 ml of toluene while sufficiently stirring, 92 µl of SiCl₄ were dripped. After stirring for one hour, a reducing agent {2 ml of lithium aluminum hydride THF solution (1M)} was dripped spending for 2 minutes or more. After standing for 3 hours, nanosized silicon particles were formed in a micelle of the surfactant by deactivating an excessive reducing agent via addition of 20 ml of methanol.

The particle diameter of the nanosized silicon particle was able to be adjusted by changing a ratio of SiCl₄ / TOAB. That is, SiCl₄ : TOAB was changed from 1 : 0.1 to 1 : 100 to obtain monodisperse particles having four kinds of particle diameters.

| | SiCl₄ : TOAB | Average particle diameter |
|---|---|---|
| Si core A | 1 : 0.1 | 30 nm |
| Si core B | 1 : 1 | 10 nm |
| Si core C | 1 : 10 | 5 nm |
| Si core D | 1 : 100 | 2 nm |

### (Covering of shell portion SiO₂ layer)

The resulting nanosized silicon particle dispersion was calcined while remaining standing in oxidant atmosphere at 1200 °C for 5 minutes employing a spray pyrolysis apparatus (RH-2, manufactured by OHKAWARA KAKOHKI Co., Ltd.) to cover a SiO₂ shell layer. In this case, the shell thickness was able to be adjusted by changing the remaining standing time, and the shell thickness was able to be thickened by lengthening the remaining standing time. Covering was conducted 5 times each in the same condition to evaluate light emission with the number of samples (N = 5).

### (Evaluation)

Ratio of core/shell: TEM observation was conducted for each of the resulting samples. At least 1000 particles of each sample were observed to determine the core particle diameter and the shell thickness. The core has a different lattice from that of the shell, and they were able to be visually observed. The ratio of core/shell of each particle was measured to obtain the mean value. The thinnest shell thickness was 0.2 nm with respect to any of core particles.

Light emission efficiency: The resulting samples each were exposed to UV light exhibiting a wavelength of 250 nm, and generated fluorescence luminance was measured employing a chromatic luminance meter CS-200 (manufactured by Konica Minolta Sensing Co., Ltd.). A level where no shell was covered with respect to each core particle diameter was set to 1 to determine relative luminance.

The relationship between shell thickness / core particle diameter (core/shell ratio) and light emission efficiency regarding the above-described Si cores A - D is shown in Figs. 1 - 4. When the ratio of shell thickness / core particle diameter falls within a given range (particle A and particle B: 0.01 - 2/1, and particle C and particle D: 0.1 - 1/2), it is to be understood that the light emission efficiency is high, and possible to be stably obtained because of less variation in distribution.

### [Example 2]

### Preparation of CdSe/ZnS

### (Preparation of core portion composed of CdSi particle)

Into a flask, charged were 0.14 g of cadmium acetate and trioctylphosphine oxide (TOPO), and the inside of the system was filled with argon and subsequently heated up to 200 °C. Into this solution, added was 1.44 cm³ of a tri-n-octylphosphine solution in which selenium was dissolved while rigorously stirring so as to give a concentration of 25 mg/cm³, and further stirring was conducted for one hour. This solution was dried while remaining standing at 300 °C for one minute employing a spray pyrolysis apparatus to obtain nanosized CdSe particle powder.

The particle diameter of the nanosized CdSe particle was able to be controlled by adjusting the amount of TOPO. TOPO was changed from 2 g to 50 g to obtain monodisperse particles having the following four kinds of particle diameters.

| | TOPO | Average particle diameter |
|---|---|---|
| CdSe core A | 2 g | 40 nm |
| CdSe core B | 5 g | 10 nm |
| CdSe core C | 20 g | 5 nm |
| CdSe core D | 50 g | 3 nm |

### (Covering of shell portion ZnS layer)

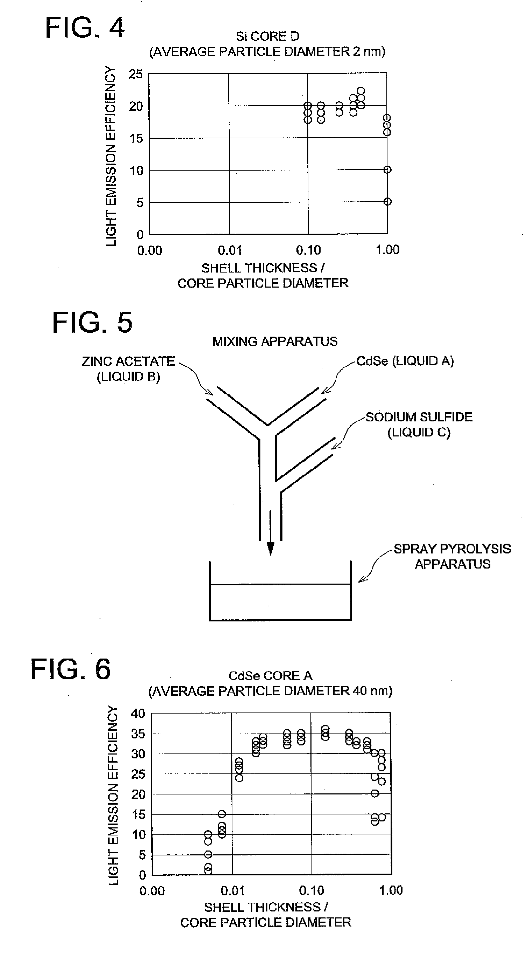

After dispersing the resulting nanosized CdSe particle powder in water employing ultrasonic waves (liquid A), a zinc acetate solution (liquid B) and subsequently a sodium sulfide solution (liquid C) were mixed at an addition speed to make a Reynolds number of the mixing portion to be 5000 employing a mixing apparatus of Fig. 5. This mixed dispersion remained left standing at 1200 °C for 5 minutes employing a spray pyrolysis apparatus to obtain nanosized particles each having a CdSe core - ZnS shell structure.

The shell thickness was possible to be adjusted depending on the concentration of the zinc acetate solution and the sodium sulfide solution. Herein, covering was conducted 5 times each in the same condition to evaluate light emission with the number of samples (N = 5).

### (Evaluation)

Ratio of core/shell: TEM observation was conducted for each of the resulting samples. At least 1000 particles of each sample were observed to determine the core particle diameter and the shell thickness. The core has a different lattice from that of the shell, and they are able to be visually observed. The ratio of core/shell of each particle was measured to obtain the mean value. The thinnest shell thickness was 0.2 nm with respect to any of core particles. Light emission efficiency: The resulting samples each were exposed to UV light exhibiting a wavelength of 250 nm, and generated fluorescence luminance was measured. A level where no shell was covered with respect to each core particle diameter was set to 1 to determine relative luminance.

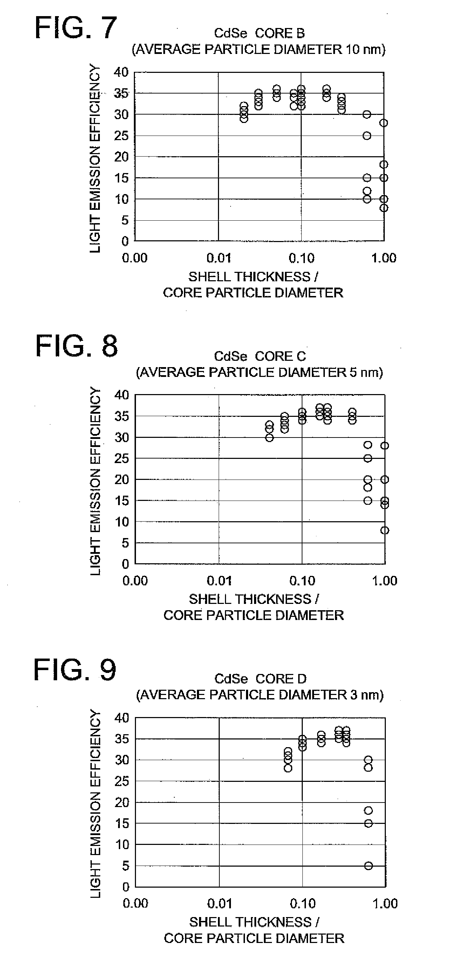

The relationship between shell thickness / core particle diameter (core/shell ratio) and light emission efficiency regarding the above-described CdSe cores A - D is shown in Figs. 6 - 9. When the ratio of shell thickness / core particle diameter falls within a given range (particle A and particle B: 0.01 - 2/1, and particle C and particle D: 0.1 - 1/2), it is to be understood that the light emission efficiency is high, and possible to be stably obtained because of less variation in distribution.

## Claims

1. A nanosized semiconductor particle comprising a core/shell structure in which a shell portion has a thickness of not more than 1/2 of a particle diameter of a core portion.

2. The nanosized semiconductor particle of Claim 1,
wherein the core portion has a particle diameter of less than 20 nm, and the shell portion has a thickness of at least 0.2 nm.

3. The nanosized semiconductor particle of Claim 1,
wherein the core portion has a particle diameter of 20 - 100 nm, and the shell portion has a thickness of at least 1/100 of a particle diameter of the core portion.

4. The nanosized semiconductor particle of any one of Claims 1 - 3,
wherein the core portion comprises an element selected from the group consisting of B, C, N, Al, Si, P, S, Zn, Ga, Ge, As, Se, Cd, In, Sb and Te.

5. The nanosized semiconductor particle of any one of Claims 1 - 4,
wherein the shell portion has a composition exhibiting a larger band gap than that of the core portion.

6. The nanosized semiconductor particle of any one of Claims 1 - 5,
wherein the core portion is composed of a silicon nucleus, and the shell portion is composed of a layer made of silicon oxide as a main component.

7. The nanosized semiconductor particle of any one of Claims 1 - 6,
wherein the core portion is composed of a single crystal.

8. A method of manufacturing the nanosized semiconductor particle of any one of Claims 1 - 6, comprising the step of:
adjusting a reaction condition during formation of the shell portion,
wherein the shell portion has a minimal thickness of 0.2 nm, and has a thickness of 1/100 and 1/2 of a particle diameter of the core portion.

9. A method of manufacturing a nanosized semiconductor particle in which a core portion is composed of a silicon nucleus, and a shell portion is composed of a layer made of silicon oxide as a main component, comprising the steps of:
(i) conducting a reaction by adding a reducing agent into a solution obtained via mixing of a silicon tetrachloride solution and an organic solvent containing a surfactant;
(ii) subsequently forming liquid droplets for nanosized silicon particles prepared in a micelle of the surfactant via a spraying treatment in oxidant atmosphere to be dispersed; and
(iii) further conducting a calcination treatment while maintaining a dispersion state in a vapor phase,
wherein the shell portion has a minimal thickness of 0.2 nm, and has a thickness of 1/100 - 1/2 of a particle diameter of the core portion via adjustment of a duration of the spraying treatment in step (ii).
